# EUROPÄISCHE PATENTSCHRIFT

(11) **EP 0 866 339 B1**
(45) Veröffentlichungstag und Bekanntmachung des Hinweises auf die Patenterteilung: **03.11.2004**
(21) Anmeldenummer: 98200719.7
(22) Anmeldetag: 06.03.1998
(51) Int. Cl.: G01R 19/10, G01R 19/06, H02P 7/63

(54) **Verfahren und Schaltungsanordnung zur Regelung eines Motors**
Method and circuit to regulate a motor
Méthode et circuit de régulation de moteur

(30) Priorität: 19.03.1997 DE 19711414
(43) Veröffentlichungstag der Anmeldung: 23.09.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Loef, Christoph, Röntgenstrasse 24, 22335 Hamburg (DE)
(74) Vertreter: von Laue, Hanns-Ulrich, Dipl.-Ing.

(56) Entgegenhaltungen:
- US-A- 4 502 106
- US-A- 4 609 983
- US-A- 4 788 493
- PATENT ABSTRACTS OF JAPAN vol. 014, no. 038 (E-878), 24.Januar 1990 & JP 01 270791 A (MITSUBISHI ELECTRIC CORP), 30.Oktober 1989,
- PATENT ABSTRACTS OF JAPAN vol. 005, no. 051 (E-051), 10.April 1981 & JP 56 001794 A (TOYO ELECTRIC MFG CO LTD), 9.Januar 1981,

## Beschreibung

Die Erfindung bezieht sich auf ein Verfahren und eine Schaltungsanordnung zur Regelung eines Motors, insbesondere eines dreiphasigen, dreisträngigen Motors, der mittels eines Wechselrichterzweige aufweisenden Wechselrichters mit einer Zwischenkreisspannung gekoppelt ist.

Ein Verfahren und eine Schaltungsanordnung zur Regelung eines dreiphasigen, dreisträngigen Motors sind aus der DE-OS 23 33 978 bekannt. Die drei Wechselrichterzweige dieser bekannten Schaltungsanordnung weisen jeweils zwei elektronische Schalter mit dazu parallelgeschalteten Freilaufdioden auf, wobei jeweils ein elektronischer Schalter jedes Wechselrichterzweiges mit dem positiven Zwischenkreispotential und jeweils der andere elektronische Schalter mit dem negativen Zwischenkreispotential gekoppelt ist. Bei dieser bekannten Schaltungsanordnung werden die Summe der Ströme der mit dem negativen Zwischenkreispotential gekoppelten elektronischen Schalter und die Summe der Ströme in den dazu parallelgeschalteten Freilaufdioden getrennt gemessen und ausgewertet.

Eine derartige getrennte Messung der Schalterströme und Freilaufdiodenströme ist heutzutage jedoch nur noch bedingt möglich, da die meisten elektronischen Schalter eine integrierte Freilaufdiode aufweisen.

United States Patent US A 4609983 offenbart ebenfalls ein Verfahren und eine Schaltungsanordnung zur Regelung eines dreiphasigen, dreisträngigen Motors, der mittels eines Wechselrichterzweige aufweisenden Wechselrichters mit einer Zwischenkreisspannung gekoppelt ist, wobei Strommeßmittel zur Ableitung je eines dem Strom in dem jeweiligen Wechselrichterzweig proportionalen Meßsignals vorgesehen sind, die Strommeßmittel bilden keine Serienschaltung mit dem ersten elektronischen Schalter und dem zweiten elektronischen Schalter zwischen dem ersten und dem zweiten Zwischenkreisspannungspol der Zwischenkreisspannung; dagegen sind die Strommeßmittel an die Verbindungspunkte des ersten und zweiten elektronischen Schalters angeschlossen.

Es ist Aufgabe der Erfindung, ein anderes Verfahren sowie eine andere Schaltungsanordnung zu schaffen, mittels welchem bzw. mittels welcher em Motor der eingangs genannten Art einfach und zuverlässig geregelt werden kann.

Diese Aufgabe wird durch ein Verfahren nach dem Anspruch 1 gelöst.

Ein wesentlicher Vorteil dieses Verfahrens und einer entsprechenden Schaltungsanordnung ist, daß die Messung der Stromsignale potentialgebunden erfolgt, wobei die Potentialbindung gegenüber einem der ersten und zweiten Zwischenkreisspannungspole der Zwischenkreisspannung bestehen kann. Dadurch sind keine kostenintensiven, potentialtrennenden Meßeinrichtungen erforderlich und die dargestellte Schaltungsanordung läßt sich sehr kostengünstig realiseren. Dadurch ist sie besonders für den Einsatz in Haushaltsgeräten, z.B. in Staubsaugern und Ventilatoren vorteilhaft.

Aus den Wechselrichterzweigen wird jeweils ein dem Zweigstrom proportionales Meßsignal abgeleitet, d.h. es erfolgt keine Aufteilung in Blindstrom und Wirkstrom. Bei einem dreiphasigen, dreisträngigen Motor werden somit drei Meßsignale aus den drei Wechselrichterzweigen abgeleitet, und aus diesen drei Meßsignalen wird ein Regelsignal, das im wesentlichen dem Betrag der Strangströme des Motors proportional ist, abgeleitet.

Bei dreiphasigen, dreisträngigen Motoren ist ein Regelsignal, das im wesentlichen dem Betrag der Strangströme des Motors proportional ist, besonders gut für eine Regelung geeignet. Für die Ableitung der dem Zweigstrom proportionalen Meßsignale aus den Wechselrichterzweigen sind keine potentialtrennenden Meßeinrichtungen erforderlich. Daher läßt sich ein solches Verfahren kostengünstig realisieren.

Eine vorteilhafte Ausgestaltung der Erfindung ist dadurch gekennzeichnet, daß das Regelsignal mittels Überlagerung der Meßsignale gebildet wird.

Eine weitere vorteilhafte Ausgestaltung der Erfindung ist dadurch gekennzeichnet, daß das Regelsignal mittels Addition der Beträge der Meßsignale gebildet wird.

Eine weitere vorteilhafte Ausgestaltung der Erfindung ist dadurch gekennzeichnet, daß aus den Meßsignalen jeweils die positiven und die negativen Signalanteile abgeleitet werden, daß die positiven Signalanteile zu einem ersten Summensignal und die negativen Signalanteile zu einem zweiten Summensignal addiert werden und daß ein Differenzsignal aus der Differenz des ersten und des zweiten Summensignals gebildet wird.

Bei einem dreiphasigen, dreisträngigen Motor werden aus den drei Meßsignalen somit drei positive und drei negative Signalanteile abgeleitet. Die drei positiven Signalanteile werden zu einem ersten Summensignal und die drei negativen Signalanteile zu einem zweiten Summensignal addiert. Danach wird aus dem ersten und dem zweiten Summensignal die Differenz gebildet.

Eine weitere vorteilhafte Ausgestaltung der Erfindung ist dadurch gekennzeichent, daß die Meßsignale und/oder die Summensignale und/oder das Differenzsignal tiefpaßgefiltert werden.

Durch die Tiefpaßfilterung der Meßsignale und/oder der Summensignale und/oder des Differenzsignals werden die Signale von hochfrequenten Signalanteilen befreit. Dadurch lassen sich die Meßsignale und/oder die Summensignale und/oder die Differenzsignale mittels einfacherer Schaltungsanordnungen weiterverarbeiten.

Eine weitere vorteilhafte Ausgestaltung der Erfindung ist dadurch gekennzeichnet, daß aus dem Differenzsignal oder aus dem ersten und dem zweiten Summensignal ein Mittelwert über ein ganzzahliges Vielfaches eines Drittels der Periode der Frequenz des Motors gebildet wird.

Durch diese Mittelwertbildung erhält man ein Gleichstromregelsignal, das unabhängig vom Modulationsgrad des Wechselrichters und unabhängig von dem Belastungsfaktor des Motors proportional dem Betrag der Strangströme des Motors ist.

Eine weitere vorteilhafte Ausgestaltung der Erfindung ist dadurch gekennzeichnet, daß ein drittes Summensignal aus der Summe der Meßsignale gebildet wird und daß aus dem Vorzeichen dieses dritten Summensignals abgeleitet wird, ob sich der Motor im motorischen oder generatorischen Betrieb befindet.

Mittels des Regelsignals und des dritten Summensignals läßt sich somit der Betriebszustand des Motors eindeutig bestimmen.

Die erfindungsgemäße Aufgabe wird für eine Schaltungsanordnung durch die Vorrichtung nach Anspruch 8 gelöst.

Bei einem dreiphasen, dreisträngigen Motor sind drei Strommeßmittel für die drei Wechselrichterzweige vorgesehen. Die mittels der drei Strommeßmittel aus den Wechselrichterzweigen abgeleiteten Meßsignale werden nachfolgend mittels der Auswertemittel weiterverarbeitet, und es wird ein dem Betrag der Strangströme des Motors proportionales Regelsignal zur Verfügung gestellt.

Bei einer bevorzugten Ausführungsform der Erfindung sind die Auswertemittel zur Überlagerung der Meßsignale ausgebildet.

Bei einer weiteren vorteilhaften Ausgestaltung der Erfindung sind Addiermittel und Betragsbildungsmittel zur Addition der Beträge der Meßsignale vorgesehen.

Eine weitere vorteilhafte Ausgestaltung der Schaltungsanordnung ist dadurch gekennzeichnet, daß Mittel vorgesehen sind, mittels derer aus den Meßsignalen jeweils die positiven und die negativen Signalanteile ableitbar sind, daß Addiermittel zur Addition der positiven Signalanteile zu einem ersten Summensignal und der negativen Signalanteile zu einem zweiten Summensignal vorgesehen sind, daß wenigstens ein Differenzmittel zur Bildung eines Differenzsignals aus dem ersten und dem zweiten Summensignal vorgesehen ist und daß wenigstens ein Integriermittel vorgesehen ist, mittels dessen aus dem Differenzsignal oder aus dem ersten und dem zweiten Summensignal ein Mittelwert über ein ganzzahliges Vielfaches eines Drittels der Periode der Frequenz des Motors bestimmbar ist.

Eine weitere vorteilhafte Ausgestaltung der Schaltungsanordnung ist dadurch gekennzeichnet, daß Filtermittel zur Tiefpaßfilterung der Meßsignale und/oder der Summensignale und/oder des Differenzsignals vorgesehen sind.

Durch diese Filtermittel werden die Meßsignale und/oder die Summensignale und/oder die Differenzsignale von hochfrequenten Signalanteilen befreit. Dadurch lassen sich die nachfolgenden Auswertemittel, Überlagerungsmittel, Addiermittel, Betragsbildungsmittel und/oder Differenzmittel durch Bausteine mit einer geringeren Bandbreite realisieren.

Besonders vorteilhaft ist eine sofortige Tiefpaßfilterung der Meßsignale.

Die Strommeßmittel lassen sich gemäß einer bevorzugten Ausführungsform der Erfindung mittels Shunt-Widerständen oder Hallsensoren verwirklichen. Es sind keine aufwendigen und teuren potentialtrennenden Meßeinrichtungen erforderlich.

Die erfindungsgemäße Schaltungsanordnung bzw. das erfindungsgemäße Verfahren läßt sich vorzugsweise zur Regelung eines Induktionsmotors oder eines bürstenlosen Gleichstrommotors verwenden. Als Applikationen für derartige Motoren mit der erfindungsgemäßen Schaltungsanordnung sind insbesondere Ventilatoren und Staubsauger geeignet.

Bei Staubsaugern und Ventilatoren ist der Kostendruck an die verwendeten Antriebe besonders groß. Daher eignet sich die einfache und kostengünstig zu realisierende erfindungsgemäße Schaltungsanordnung hier besonders gut.

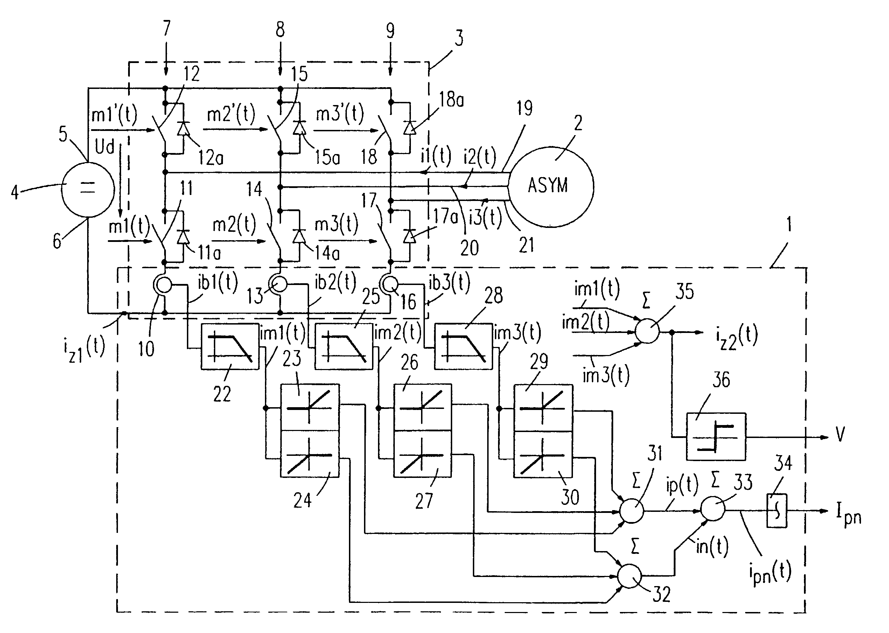

Ein schematisch dargestelltes Ausführungsbeispiel der Erfindung wird anhand der einzigen Figur der Zeichnung näher erläutert.

Die einzige Figur der Zeichnung zeigt eine Schaltungsanordnung 1 zur Regelung eines dreiphasigen, dreisträngigen Asynchronmotors 2, der mittels eines Wechselrichters 3 mit einer Zwischenkreis-Spannungsquelle 4 gekoppelt ist. Die Zwischenkreis-Spannungsquelle 4 weist einen positiven Zwischenkreis-Spannungspol 5 und einen negativen Zwischenkreis-Spannungspol 6 auf. Der Pulswechselrichter 3 weist einen ersten Wechselrichterzweig 7, einen zweiten Wechselrichterzweig 8 und einen dritten Wechselrichterzweig 9 auf. Der erste Wechselrichterzweig 7, der zweite Wechselrichterzweig 8 und der dritte Wechselrichterzweig 9 sind parallelgeschaltet. Der erste Wechselrichterzweig 7 weist eine Serienschaltung aus einem ersten Strommeßmittel 10, einem ersten elektronischen Schalter 11 und einem zweiten elektronischen Schalter 12 auf. Das erste Strommeßmittel 10 ist mit dem negativen Zwischenkreis-Spannungspol 6 und der zweite elektronische Schalter 12 mit dem positiven Zwischenkreis-Spannungspol 5 gekoppelt. Zu dem ersten elektronischen Schalter 11 ist eine erste Freilaufdiode 11a und zu dem zweiten elektronischen Schalter 12 eine zweite Freilaufdiode 12a parallelgeschaltet.

Der zweite Wechselrichterzweig 8 weist eine Serienschaltung aus einem zweiten Strommeßmittel 13, einem dritten elektronischen Schalter 14 und einem viereten elektronischen Schalter 15 auf. Das zweite Strommeßmittel 13 ist mit dem negativen Zwischenkreis-Spannungspol 6 und der vierte elektronische Schalter 15 mit dem positiven Zwischenkreis-Spannungspol 5 gekoppelt. Zu dem dritten elektronischen Schalter 14 ist eine dritte Freilaufdiode 14a und zu dem vierten elektronsichen Schalter 15 eine vierte Freilaufdiode 15a parallelgeschaltet.

Der dritte Wechselrichterzweig 9 besteht aus einer Serienschaltung aus einem dritten Strommeßmittel 16, einem fünften elektronischen Schalter 17 und einem sechsten elektronischen Schalter 18. Das dritte Strommeßmittel 16 ist mit dem negativen Zwischenkreis-Spannungspol 6 und der sechste elektronische Schalter 18 mit dem positiven Zwischenkreis-Spannungspol 5 gekoppelt. Zu dem fünften elektronischen Schalter 17 ist eine fünfte Freilaufdiode 17a und zu dem sechsten elektronischen Schalter 18 eine sechste Freilaufdiode 18a parallelgeschaltet.

Der dreiphasige, dreisträngige Asynchronmotor 2 weist einen ersten Strang 19, einen zweiten Strang 20 und einen dritten Strang 21 auf.

Der erste Strang 19 ist mit dem Zweig, der den ersten elektronischen Schalter 11 und den zweiten elektronischen Schalter 12 verbindet, verbunden. Der zweite Strang 20 ist mit dem Verbindungszweig, der den dritten elektronischen Schalter 14 und den vierten elektronischen Schalter 15 verbindet, verbunden. Der dritte Strang 21 ist mit dem Verbindungszweig, der den fünften elektronischen Schalter 17 und den sechsten elektronischen Schalter 18 verbindet, verbunden.

In dem ersten Strang 19 fließt ein erster Strangstrom i₁(t), in dem zweiten Strang 20 ein zweiter Strangstrom i₂(t) und in dem dritten Strang 21 ein dritter Strangstrom i₃(t). In dem Zwischenkreis mit der Zwischenkreisspannungsquelle 4 fließt ein Zwischenkreisstrom i_{z1}(t).

Der erste elektronische Schalter 11 wird mittels einer Schaltfunktion m₁(t) geschaltet, der zweite elektronische Schalter 12 mittels einer Schaltfunktion m₂(t) und der dritte Schalter 14 mittels einer Schaltfunktion m₃(t). Der vierte Schalter 15 wird mit der zu der ersten Schaltfunktion m₁(t) inversen Schaltfunktion m'₁(t) geschaltet, der fünfte Schalter 17 mit einer zu der zweiten Schaltfunktion m₂(t) inversen Schaltfunktion m'₂(t), und der sechste elektronische Schalter 18 wird mittels einer zu der dritten Schaltfunktion m₃(t) inversen Schaltfunktion m'₃(t) gesteuert.

Das erste Strommeßmittel 10 ist mit einem ersten Tiefpaß 22 gekoppelt, dessen Ausgang mit einer Parallelschaltung aus einem ersten Positivanteil-Bildungsmittel 23 und einem ersten Negativanteil-Bildungsmittel 24 gekoppelt ist. Das zweite Strommeßmittel 13 ist mit einem zweiten Tiefpaß 25 gekoppelt, dessen Ausgang mit einer Parallelschaltung aus einem zweiten Positivanteil-Bildungsmittel 26 und einem zweiten Negativanteil-Bildungsmittel 27 gekoppelt ist.

Das dritte Strommeßmittel 16 ist mit einem dritten Tiefpaß 28 gekoppelt, dessen Ausgang mit einer Parallelschaltung aus einem dritten Positivanteil-Bildungsmittel 29 und einem dritten Negativanteil-Bildungsmittel 30 gekoppelt ist.

Die Ausgänge des ersten, zweiten und dritten Positivanteil-Bildungsmittels 23, 26 bzw. 29 sind mit einem ersten Addierer 31 gekoppelt, die Ausgänge des ersten, zweiten und dritten Negativanteil-Bildungsmittels 24, 27 bzw. 30 sind mit einem zweiten Addierer 32 gekoppelt. Die Ausgänge des ersten Addierers 31 und des zweiten Addierers 32 werden auf ein Differenz-Bildungsmittel 33 geführt. Der Ausgang des Differenzbildungsmittels 33 ist mit einem ersten Integriermittel 34 gekoppelt.

Es ist ein dritter Addierer 35 vorgesehen, dem die Ausgangssignale des ersten Tiefpasses 22, des zweiten Tiefpasses 25 und des dritten Tiefpasses 28 zugeführt werden. Der Ausgang des dritten Addierers 35 ist mit einem Vorzeichen-Bestimmungsmittel 36 gekoppelt, welches als Vorzeichensignal V positive Signalanteile auf einen positiven Bezugswert und negative Signalanteile auf einen negativen Bezugswert setzt.

Nachfolgend wird die Bestimmung des Betrages des ersten Strangstrom i,(t), des zweiten Strangstromes i₂(t) bzw. des dritten Strangstromes i₃(t) mittels der Schaltungsanordnung 1 näher erläutert.

Dem ersten Tiefpaß 22 wird von dem ersten Strommeßmittel 10 als Meßsignal ein Stromsignal i_{b1}(t) zugeführt, welches dem in dem ersten Wechselrichterzweig 7 fließenden Strom proportional ist. Dem zweiten Tiefpaß 25 wird von dem zweiten Strommeßmittel 13 als Meßsignal ein Stromsignal i_{b2}(t) zugeführt, welches dem Strom in dem zweiten Wechselrichterzweig 8 proportional ist. Dem dritten Tiefpaß 28 wird von dem dritten Strommeßmittel 16 als Meßsignal ein Stromsignal i_{b3}(t) zugeführt, welches dem Strom in dem dritten Wechselrichterzweig 9 proportional ist. Der erste Tiefpaß 22, der zweite Tiefpaß 25 und der dritte Tiefpaß 28 haben jeweils eine Eckfrequenz, welche unterhalb der halben Schaltfrequenz des Wechselrichters liegt. Am Ausgang des ersten Tiefpasses 22 liegt dann ein Signal iₘ₁(t) an, am Ausgang des zweiten Tiefpasses 25 ein Signal iₘ₂(t) und am Ausgang des dritten Tiefpasses 28 ein Signal iₘ₃(t). Die tiefpaßgefilterten Signale iₘ₁(t), iₘ₂(t) und iₘ₃(t) entsprechen der Integration der Stromsignale i_{b1}(t), i_{b2}(t) und i_{b3}(t) über eine Schaltperiode des Wechselrichters 3. Mittels des ersten Positivanteil-Bildungsmittels 23, des zweiten Positivanteil-Bildungsmittels 26 bzw. des dritten Positivanteil-Bildungsmittels 29 werden aus den tiefpaßgefilterten Signalen iₘ₁(t), iₘ₂(t) bzw. iₘ₃(t) die positiven Signalanteile abgeleitet und dem ersten Addierer 31 zugeführt. Mittels des ersten Negativanteil-Bildungsmittels 24, des zweiten Negativanteil-Bildungsmittels 27 bzw. des dritten Negativanteil-Bildungsmittels 30 werden aus den tiefpaßgefilterten Signalen iₘ₁(1), iₘ₂(t) bzw. iₘ₃(t) die negativen Signalanteile abgeleitet und dem zweiten Addierer 32 zugeführt. Am Ausgang des ersten Addierers 31 steht dann ein erstes Summensignal iₚ(t) zur Verfügung, und am Ausgang des zweiten Addierers 32 steht ein zweites Summensignal iₙ(t) zur Verfügung. Mittels des Differenz-Bildungsmittels 33 wird dann die Differenz aus dem Summensignal iₚ(t) der positiven Signalanteile und dem Summensignal iₙ(t) der negativen Signalanteile gebildet. Am Ausgang des Differenzbildungsmittels 33 steht ein Differenzsignal iₚₙ(t) zur Verfügung. Mittels des ersten Integriermittels 34 wird aus diesem Signal iₚₙ(t) als Regelsignal ein Mittelwert Iₚₙ über ein ganzzahliges Vielfaches eines Drittels der Periode der Frequenz des Motors gebildet. Dieser Mittelwert Iₚₙ ist eine dem Betrag der Strangströme i₁(t), i₂(t) und i₃(t) proportionale Größe. Der Mittelwert Iₚₙ ist unabhängig vom Lastfaktor cos ϕ der Asynchronmaschine 2, dem Modulationsgrad des Wechselrichters 3.

Die am Ausgang des ersten Tiefpasses 22, des zweiten Tiefpasses 25 und des dritten Tiefpasses 28 anliegenden Signale iₘ₁(t), iₘ₂(t) und iₘ₃(t) werden auf nicht näher dargestellte Weise einem dritten Addierer 35 zugeführt. In dem dritten Addierer 35 werden die Signale iₘ₁(t), iₘ₂(t) und iₘ₃(t) zu einem Summensignal i_{z2}(t) addiert. Dieses Summensignal i_{z2}(t) ist proportional zu dem Zwischenkreisstrom i_{z1}(t). Mittels des Vorzeichen-Bestimmungsmittels 36 wird aus diesem Signal i_{z2}(t) das Vorzeichensignal V bestimmt. Aus dem Vorzeichensignal V der Größe i_{z2}(t) läßt sich ableiten, ob sich der Asynchronmotor 2 im generatorischen oder motorischen Betrieb befindet.

Somit liefert die Schaltungsanordnung 1 ein dem Betrag der Strangströme i₁(t), i₂(t) und i₃(t) der Asynchronmaschine 2 proportionales Regelsignal Iₚₙ, das in einer nicht näher dargestellten Steuer- bzw. Regelschaltung verwendbar ist. Dieses Regelsignal Iₚₙ wird ergänzt durch das Vorzeichensignal V, welches am Ausgang des Vorzeichen-Bestimmungsmittels 36 zur Verfügung steht. Durch eine geeignete Auswertung des Regelsignals Iₚₙ und des Vorzeichensignals V kann für alle Betriebszustände der Asynchronmaschine 2 auf den Statorwirkstrom und den Phasenwinkel der Asynchronmaschine 2 eindeutig geschlossen werden.

Ein wesentlicher Vorteil der beschriebenen Schaltungsanordnung besteht darin, daß die Messung der Stromsignale i_{b1}(t), i_{b2}(t) und i_{b3}(t) potentialgebunden erfolgt, wobei die Potentialbindung gegenüber dem negativen Zwischenkreis-Spannungspol 6 besteht. Dadurch sind keine kostenintensiven, potentialtrennenden Meßeinrichtungen erforderlich, und die dargestellte Schaltungsanordnung läßt sich sehr kostengünstig realisieren. Dadurch ist sie besonders für den Einsatz in Haushaltsgeräten vorteilhaft, z.B. in Staubsaugern und Ventilatoren.

Das erste Strommeßmittel 10, das zweite Strommeßmittel 13 und das dritte Strommeßmittel 16 lassen sich beispielsweise mittels eines Shunts oder mittels eines Hallsensors realisieren. Der erste Tiefpaß 22, der zweite Tiefpaß 25 und der dritte Tiefpaß 28 lassen sich beispielsweise mittels RC-Gliedern realisieren. Die Positivanteil-Bildungsmittel 23, 26 und 29 sowie die Negativanteil-Bildungsmittel 24, 27 und 30 lassen sich beispielsweise mittels Operationsverstärkern realisieren. Der erste Addierer 31 und der zweite Addierer 32 lassen sich beispielsweise durch einfache Zusammenführung der Signale iₚ₁(t), iₚ₂(t) und iₚ₃(t) bzw. iₙ₁(t), iₙ₂(t) und iₙ₃(t) realisieren. Das Differenz-Bildungsmittel 33 läßt sich beispielsweise mittels eines Operationsverstärkers realisieren. Das erste Integriermittel 34 kann beispielsweise mittels eines Tiefpasses realisiert werden. Es ist aber auch denkbar, daß die Größe iₚₙ(t) in diskreten Intervallen durch einen Mikroprozessor erfaßt wird und anschließend mittels dieses Mikroprozessors der Mittelwert Iₚₙ gebildet wird

Die direkte Tiefpaßfilterung der Meßsignale i_{b1}(t), i_{b2}(t) und i_{b3}(t) hat den Vorteil, daß die weitere Verarbeitung dieser Meßsignale durch Bauelemente mit geringer Bandbreite realisiert werden kann.

Es ist jedoch auch möglich, die Tiefpässe 22, 25 und 28 hinter den ersten Addierer 31 bzw. den zweiten Addierer 32 oder auch hinter das Differenz Bildungsmittel 33 zu plazieren. Dann sind jedoch aktive Komponenten mit höherer Bandbreite erforderlich, was höhere Komponentenkosten zur Folge hat.

## Patentansprüche

1. Verfahren zur Regelung eines Motors (2), insbesondere eines dreiphasigen, dreisträngigen Motors (2), der mittels eines Wechselrichterzweige (7, 8, 9) aufweisenden Wechselrichters (3) mit einer Zwischenkreisspannung (4) gekoppelt ist, wobei aus den Wechselrichterzweigen (7, 8, 9) jeweils ein dem Zweigstrom proportionales Meßsignal (i_{b1}, i_{b2}, i_{b3}) mittels eines Strommeßmittels (10, 13, 16) abgeleitet wird, und aus den Meßsignalen (i_{b1}, i_{b2}, i_{b3}) ein Regelsignal (Iₚₙ), das im wesentlichen dem Betrag der Strangströme (i_{1,} i_{2,} i₃) des Motors (2) proportional ist, abgeleitet wird, **dadurch gekennzeichnet, daß** jeder der Wechselrichterzweige (7, 8, 9) eine Serienschaltung aus dem Strommeßmittel (10, 13, 16), einem ersten elektronischen Schalter (11, 14, 17) und einem zweiten elektronischen Schalter (12, 15, 18) zwischen einem ersten (5) und einem zweiten (6) Zwischenkreisspannungspol der Zwischenkreisspannung (4) aufweist.

2. Verfahren nach Anspruch 2, **dadurch gekennzeichnet, daß** das Regelsignal mittels Überlagerung der Meßsignale (i_{b1}, i_{b2}, i_{b3}) gebildet wird.

3. Verfahren nach Anspruch 1 oder 2, **dadurch gekennzeichnet, daß** das Regelsignal (Iₚₙ) mittels Addition der Beträge der Meßsignale (i_{b1,} i_{b2,} i_{b3}) gebildet wird.

4. Verfahren nach einem der Ansprüche 1 bis 3, **dadurch gekennzeichnet,**
**daß** aus den Meßsignalen (i_{b1,}i_{b2,} i_{b3}) jeweils die positiven und die negativen Signalanteile abgeleitet werden,
**daß** die positiven Signalanteile zu einem ersten Summensignal (iₚ) und die negativen Signalanteile zu einem zweiten Summensignal (iₙ) addiert werden und daß ein Differenzsignal (iₚₙ) aus der Differenz des ersten (iₚ) und des zweiten (iₙ) Summensignals gebildet wird.

5. Verfahren nach Anspruch 4, **dadurch gekennzeichnet, daß** die Meßsignale (i_{b1,} i_{b2,} i_{b3}) und/oder die Summensignale (i_{p,} iₙ) und/oder das Differenzsignal (iₚₙ) tiefpaßgefiltert werden.

6. Verfahren nach Anspruch 4 oder 5, **dadurch gekennzeichnet, daß** aus dem Differenzsignal (iₚₙ) oder aus dem ersten (iₚ) und dem zweiten (iₙ) Summensignal ein Mittelwert (Iₚₙ) über ein ganzzahliges Vielfaches eines Drittels der Periode der Frequenz des Motors gebildet wird.

7. Verfahren nach einem der Ansprüche 1 bis 6, **dadurch gekennzeichnet, daß** ein drittes Summensignal (i_{z2}) aus der Summe der Meßsignale (i_{b1,} i_{b2,} i_{b3}) gebildet wird und daß aus dem Vorzeichen dieses dritten Summensignals (i_{z2})abgeleitet wird, ob sich der Motor (2) im motorischen oder generatorischen Betrieb befindet.

8. Schaltungsanordnung zur Regelung eines Motors (2), insbesondere eines dreiphasigen, dreisträngigen Motors (2), der mittels eines Wechselrichterzweige (7, 8, 9) aufweisenden Wechselrichters (3) mit einer Zwischenkreisspannung (4) gekoppelt ist, wobei in jedem der Wechselrichterzweige (7, 8, 9) Strommeßmittel (10, 13, 16) zur Ableitung je eines dem Strom in dem jeweiligen Wechselrichterzweig (7, 8, 9) proportionalen Meßsignals (i_{b1}, i_{b2}, i_{b3}) und Auswertemittel (23, 26, 29, 24, 27, 30, 31, 32, 34) zur Ableitung eines dem Betrag der Strangströme (i_{1,} i_{2,} i₃) des Motors (2) proportionalen Regelsignales (Iₚₙ) aus den Meßsignalen (i_{b1,} i_{b2,} i_{b3}) vorgesehen sind **dadurch gekennzeichnet, daß** jeder der Wechselrichterzweige (7, 8, 9) eine Serienschaltung aus dem Strommeßmittel (10, 13, 16), einem ersten elektronischen Schalter (11, 14, 17) und einem zweiten elektronischen Schalter (12, 15, 18) zwischen einem ersten (5) und einem zweiten (6) Zwischenkreisspannungspol der Zwischenkreisspannung (4) aufweist.

9. Schaltungsanordung nach Anspruch 8, **dadurch gekennzeichnet, daß** die Auswertemittel (23, 26, 29, 24, 27, 30, 31, 32, 34) zur Überlagerung der Meßsignale (i_{b1,} i_{b2,} i_{b3}) ausgebildet sind.

10. Schaltungsanordnung nach Anspruch 9, **dadurch gekennzeichnet, daß** Addiermittel und Betragsbildungsmittel zur Addition der Beträge der Meßsignale (i_{b1}, i_{b2}, i_{b3}) vorgesehen sind.

11. Schaltungsanordnung nach einem der Ansprüche 8 bis 10, **dadurch gekennzeichnet,**
**daß** Mittel (23, 26, 29; 24, 27, 30) vorgesehen sind, mittels derer aus den Meßsignalen jeweils die positiven und die negativen Signalanteile ableitbar sind, daß Addiermittel (31, 32) zur Addition der positiven Signalanteile zu einem ersten Summensignal (iₚ) und der negativen Signalanteile zu einem zweiten Summensignal (iₙ) vorgesehen sind,
**daß** wenigstens ein Differenzmittel (33) zur Bildung eines Differenzsignals (iₚₙ) aus dem ersten (iₚ) und dem zweiten Summensignal (iₙ) vorgesehen ist und
**daß** wenigstens ein Integriermittel (34) vorgesehen ist, mittels dessen aus dem Differenzsignal (iₚₙ) oder aus dem ersten (iₚ) und dem zweiten (iₙ) Summensignal ein Mittelwert (Iₚₙ) über ein ganzzahliges Vielfaches eines Drittels der Periode der Frequenz des Motors bestimmbar ist.

12. Schaltungsanordnung nach einem der Ansprüche 1 bis 11, **dadurch gekennzeichnet, daß** Filtermittel (22, 25, 28) zur Tiefpaßfilterung der Meßsignale (i_{b1,} i_{b2,} i_{b3}) und/oder der Summensignale (i_{p,} iₙ) und/oder des Differenzsignals (iₚₙ) vorgesehen sind.

13. Schaltungsanordnung nach einem der Ansprüche 8 bis 12, **dadurch gekennzeichnet, daß** die Strommeßmittel (10, 13, 16) Shunt-Widerstände oder Hall-Sensoren sind.

14. Induktionsmotor (2) mit einer Schaltungsanordnung nach einem der Anprüche 8 bis 13.

15. Bürstenloser Gleichstrommotor mit einer Schaltungsanordnung nach einem der Anprüche 8 bis 13.

16. Ventilator mit einer Schaltungsanordnung nach einem der Anprüche 8 bis 13.

17. Staubsauger mit einer Schaltungsanordnung nach einem der Anprüche 8 bis 13.

## Claims

1. A method of controlling a motor (2), in particular a three-phase, three-strand motor (2) which is coupled to an intermediate circuit voltage (4) via a DC/AC converter (3) which comprises DC/AC converter branches (7, 8, 9), wherein a measuring signal (i_{b1}, i_{b2}, i_{b3}) which is proportional to the respective branch current is derived from each of the DC/AC converter branches (7, 8, 9) by a current measuring means (10, 13, 16), and a control signal (Iₚₙ) substantially proportional to the total value of the strand currents (i₁, i₂, i₃) of the motor (2) is derived from the measuring signals (i_{b1}, i_{b2}, i_{b3}), and wherein a control signal (Iₚₙ) which is substantially proportional to the total value of the strand currents (i₁, i₂, i₃) of the motor (2) is derived from the measuring signals (i_{b1}, i_{b2}, i_{b3}), **characterized in that** each of the DC/AC converter branches (7, 8, 9) comprises a series arrangement formed by the current measuring means (10, 13, 16), a first electronic switch (11, 14, 17), and a second electronic switch (12, 15, 18) between a first (5) and a second (6) intermediate circuit voltage pole of the intermediate circuit voltage (4).

2. A method as claimed in claim 1, **characterized in that** the control signal is formed by means of a superimposition of the measuring signals (i_{b1,} i_{b2,} i_{b3}).

3. A method as claimed in claim 1 or 2, **characterized in that** the control signal (Iₚₙ) is formed by means of adding together of the values of the measuring signals (i_{b1,} i_{b2,} i_{b3}).

4. A method as claimed in any one of the claims 1 to 3, **characterized**
**in that** the positive and the negative signal components are derived from each of the measuring signals (i_{b1,} i_{b2,} i_{b3}),
**in that** the positive signal components are added into a first summed signal (iₚ) and the negative signal components are added into a second summed signal (iₙ), and
**in that** a differential signal (iₚₙ) is formed from the difference between the first (iₚ) and the second summed signal (iₙ).

5. A method as claimed in claim 4, **characterized in that** the measuring signals (i_{b1,} i_{b2,} i_{b3}) and/or the summed signals (iₚ, iₙ) and/or the differential signal (iₚₙ) are low-pass filtered.

6. A method as claimed in claim 4 or 5, **characterized in that** an average value (Iₚₙ), averaged over an integer multiple of one third of the frequency cycle of the motor, is formed from the differential signal (iₚₙ) or from the first (iₚ) and the second summed signal (iₙ).

7. A method as claimed in any one of the claims 1 to 6, **characterized in that** a third summed signal (i_{z2}) is formed from the sum of the measuring signals (i_{b1,} i_{b2,} i_{b3}), and **in that** it is derived from the sign of this third summed signal (i_{z2}) whether the motor (2) is in its motor or generating phase.

8. A circuit arrangement for controlling a motor (2), in particular a three-phase, three-strand motor (2) which is coupled to an intermediate circuit voltage (4) via a DC/AC converter (3) which comprises DC/AC converter branches (7, 8, 9), wherein current-measuring means (10, 13, 16) are provided in each of the DC/AC converter branches (7, 8, 9) for deriving a measuring signal (i_{b1,} i_{b2,} i_{b3}) which is proportional to the current present in the relevant DC/AC converter branch (7, 8, 9), and evaluation means (23, 26, 29, 24, 27, 30, 31, 32, 34) are provided for deriving from the measuring signals (i_{b1,} i_{b2,} i_{b3}) a control signal (Iₚₙ) which is proportional to the total value of the strand currents (i_{1,} i_{2,} i₃) of the motor (2), **characterized in that** each of the DC/AC converter branches (7, 8, 9) comprises a series arrangement formed by the current measuring means (10, 13, 16), a first electronic switch (11, 14, 17), and a second electronic switch (12, 15, 18) between a first (5) and a second (6) intermediate circuit voltage pole of the intermediate circuit voltage (4).

9. A circuit arrangement as claimed in claim 8 **characterized in that** the evaluation means (23, 26, 29, 24, 27, 30, 31, 32, 34) are designed for superimposing the measuring signals (i_{b1}, i_{b2}, i_{b3}).

10. A circuit arrangement as claimed in claim 9, **characterized in that** adding means and summation means are provided for adding the total values of the measuring signals (i_{b1,} i_{b2,} i_{b3}).

11. A circuit arrangement as claimed in any one of the claims 8 to 10, **characterized**
**in that** means (23, 26, 29; 24, 27, 30) are provided by which the positive and the negative signal components can be derived from each of the measuring signals,
**in that** adding means (31, 32) are provided for adding together the positive signal components so as to form a first summed signal (iₚ) and the negative components so as to form a second summed signal (iₙ),
**in that** at least one difference means (33) for forming a differential signal (iₚₙ) from the first (iₚ) and the second summed signal (iₙ) is provided, and
**in that** at least one integration means (34) is provided which is capable of determining an average value (Iₚₙ), averaged over an integer multiple of one third of a frequency cycle of the motor, from the differential signal (iₚₙ) or from the first (iₚ) and the second summed signal (iₙ.).

12. A circuit arrangement as claimed in any one of the claims 8 to 11, **characterized in that** filter means (22, 25, 28) are provided for low-pass filtering of the measuring signals (i_{b1}, i_{b2}, i_{b3}) and/or the summed signals (iₚ, iₙ) and/or the differential signal (iₚₙ).

13. A circuit arrangement as claimed in any one of the claims 8 to 12, **characterized in that** the current-measuring means (10, 13, 16) are realized by means of shunt resistors or Hall sensors.

14. An induction motor (2) comprising a circuit arrangement as claimed in any one of the claims 8 to 13.

15. A brushless DC motor comprising a circuit arrangement as claimed in any one of the claims 8 to 13.

16. A fan comprising a circuit arrangement as claimed in any one of the claims 8 to 13.

17. A vacuum cleaner comprising a circuit arrangement as claimed in any one of the claims 8 to 13.

## Revendications

1. Procédé de réglage d'un moteur (2), en particulier d'un moteur (2) triphasé à trois voies qui est couplé à l'aide d'un onduleur (3) présentant des branches d'onduleur (7, 8, 9) à une tension de circuit intermédiaire (4), dans lequel un signal de mesure (i_{b1,} i_{b2,} i_{b3}) proportionnel au courant de branche est respectivement déduit à l'aide d'un moyen de mesure de courant (10, 13, 16) des branches de l'onduleur (7, 8, 9) et un signal de réglage (Iₚₙ) qui est essentiellement proportionnel à la valeur des courants de voie (i_{1,} i_{2,} i₃) du moteur (2) est dérivé des signaux de mesure (i_{b1,} i_{b2,} i_{b3}), **caractérisé en ce que** chacune des branches d'onduleur (7, 8, 9) présente un montage en série du moyen de mesure de courant (10, 13, 16), un premier commutateur électronique (11, 14, 17) et un deuxième commutateur électronique (12, 15, 18) entre un premier (5) et un deuxième (6) pôle de tension de circuit intermédiaire de la tension du circuit intermédiaire (4).

2. Procédé selon la revendication 2, **caractérisé en ce que** le signal de réglage est formé à l'aide de la superposition des signaux de mesure (i_{b1,} i_{b2,} i_{b3}).

3. Procédé selon la revendication 1 ou 2, **caractérisé en ce que** le signal de réglage (Iₚₙ) est formé par l'addition des valeurs des signaux de mesure (i_{b1,} i_{b2,} i_{b3}).

4. Procédé selon l'une des revendications 1 à 3, **caractérisé en ce que** les composantes de signal positives et négatives sont dérivées respectivement des signaux de mesure (i_{b1,} i_{b2,} i_{b3}),
que les composantes de signal positives sont additionnées à un premier signal de somme (iₚ) et les composantes de signal négatives à un deuxième signal de somme (i_{b}) et qu'un signal de différence (iₚₙ) est formé à partir de la différence des premier (iₚ) et deuxième (iₙ) signaux de somme.

5. Procédé selon la revendication 4, **caractérisé en ce que** les signaux de mesure (i_{b1,} i_{b2,} i_{b3}) et/ou les signaux de somme (iₚ, iₙ) et/ou le signal de différence (Iₚₙ) font l'objet d'un filtrage passe-bas.

6. Procédé selon l'une des revendications 4 ou 5, **caractérisé en ce qu'**une valeur moyenne (iₚₙ) est formée à partir du signal de différence (iₚₙ) ou des premier (iₚ) et deuxième (iₙ) signaux de somme par l'intermédiaire d'un multiple entier d'un tiers de la période de la fréquence du moteur.

7. Procédé selon l'une des revendications 1 à 6, **caractérisé en ce qu'**un troisième signal de somme (i_{z2}) est formé à partir de la somme des signaux de mesure (i_{b1,} i_{b2,} i_{b3}) et qu'à partir du signe de ce troisième signal de somme (i_{z2})_{,} on déduit si le moteur se trouve en mode moteur ou générateur.

8. Circuit de réglage d'un moteur (2), en particulier d'un moteur (2) triphasé à trois voies qui est couplé à l'aide d'un onduleur (3) présentant des branches d'onduleur (7, 8, 9) à une tension de circuit intermédiaire (4), dans lequel un signal de mesure (i_{b1,} i_{b2,} i_{b3}) proportionnel au courant de branche est respectivement déduit à l'aide d'un moyen de mesure de courant (10, 13, 16) des branches de l'onduleur (7, 8, 9) et un signal de réglage (Iₚₙ) qui est essentiellement proportionnel à la valeur des courants de voie (i1, i2, i3) du moteur (2) est dérivé des signaux de mesure (i_{b1,} i_{b2,} i_{b3}), **caractérisé en ce que** chacune des branches d'onduleur (7, 8, 9) présente un montage en série du moyen de mesure de courant (10, 13, 16), un premier commutateur électronique (11, 14, 17) et un deuxième commutateur électronique (12, 15, 18) entre un premier (5) et un deuxième (6) pôle de tension de circuit intermédiaire de la tension du circuit intermédiaire (4).

9. Circuit selon la revendication 8, **caractérisé en ce que** des moyens d'évaluation (23, 26, 29, 24, 27, 30, 31, 32, 34) sont conçus pour la superposition des signaux de mesure (i_{b1,} i_{b2,} i_{b3}).

10. Circuit selon la revendication 9, **caractérisé en ce que** des moyens d'addition et des moyens de formation de valeur sont prévus pour l'addition des valeurs des signaux de mesure (i_{b1,} i_{b2,} i_{b3}).

11. Circuit selon l'une des revendications 8 à 10, **caractérisé en ce qu'**il est prévu des moyens (23, 26, 29; 24, 27, 30) à l'aide desquels des composantes de signal positives et négatives peuvent respectivement être dérivées des signaux de mesure, que des moyens d'addition (31, 32) sont prévus pour l'addition des composantes de signal positives à un premier signal de somme (iₚ) et des composantes de signal négatives à un deuxième signal de somme (in),
qu'au moins un moyen différentiel (33) est prévu pour la formation d'un signal de différence (iₚₙ) à partir des premier (iₚ) et deuxième (iₙ) signaux de somme et
qu'il est prévu au moins un moyen d'intégration (34) à l'aide duquel une valeur moyenne (iₚₙ) peut être déterminée à partir du signal de différence (iₚₙ) ou des premier et (iₚ) et deuxième (iₙ) signaux de somme par l'intermédiaire d'un multiple entier d'un tiers de la période de la fréquence du moteur.

12. Circuit selon l'une des revendications 1 à 11, **caractérisé en ce que** des moyens de filtre (22, 25, 28) sont prévus pour le filtrage passe-bas des signaux de mesure (i_{b1,} i_{b2,} i_{b3}) et/ou des signaux de somme (i_{p,} iₙ) et/ou du signal de différence (iₚₙ).

13. Circuit selon l'une des revendications 8 à 12, **caractérisé en ce que** les moyens de mesure du courant (10, 13, 16) sont des résistances de shunt ou des sondes de Hall.

14. Moteur d'induction (2) avec un circuit selon l'une des revendications 8 à 13.

15. Moteur à courant continu sans balai avec un circuit selon l'une des revendications 8 à 13.

16. Ventilateur avec un circuit selon l'une des revendications 8 à 13.

17. Aspirateur avec un circuit selon l'une des revendications 8 à 13.
